# EUROPÄISCHE PATENTSCHRIFT

(11) **EP 2 188 859 B1**
(45) Veröffentlichungstag und Bekanntmachung des Hinweises auf die Patenterteilung: **24.04.2013**
(21) Anmeldenummer: 08801152.3
(22) Anmeldetag: 12.08.2008
(51) Int. Cl.: H01L 51/52

(54) **STRAHLUNGSEMITTIERENDE VORRICHTUNG**
RADIATION-EMITTING DEVICE
DISPOSITIF ÉMETTEUR DE RAYONNEMENT

(30) Priorität: 10.09.2007 DE 102007043099; 05.12.2007 DE 102007058453
(43) Veröffentlichungstag der Anmeldung: 26.05.2010
(73) Patentinhaber: OSRAM Opto Semiconductors GmbH, 93055 Regensburg (DE)
(72) Erfinder: KRUMMACHER, Benjamin Claus, 93057 Regensburg (DE); SCHINDLER, Florian, 83278 Traunstein (DE); KLEIN, Markus, 93105 Tegernheim (DE)
(74) Vertreter: Epping - Hermann - Fischer
(86) Internationale Anmeldenummer: PCT/DE2008/001329
(87) Internationale Veröffentlichungsnummer: WO 2009/033444

(56) Entgegenhaltungen:
- EP-A- 1 589 584
- JP-A- 10 172 756
- US-A1- 2003 164 679
- US-A1- 2006 214 572

## Beschreibung

Die vorliegende Erfindung betrifft eine strahlungsemittierende Vorrichtung, die aufweist einen zur Emission elektromagnetischer Strahlung ausgebildeten aktiven Bereich.

Die Druckschrift US 2003/0164679 A1 betrifft ein organisches, elektrolumineszentes Element und eine Bildanzeigeeinrichtung.

In der Druckschrift EP 1 589 584 A2 ist ein Bauteil für ein flaches Display angegeben.

Ein Licht emittierendes Bauteil ist in der Druckschrift US 2006/0214572 A1 offenbart.

In der Druckschrift JP 10-172756 A ist ein organisches, Licht emittierendes Bauteil beschrieben.

Die Aufgabe der Erfindung ist es, eine strahlungsemittierende Vorrichtung zu schaffen, mit der in einfacher Weise ein über einen langen Zeitraum hoher Wirkungsgrad der Strahlungsauskopplung der strahlungsemittierenden Vorrichtung ermöglicht ist.

Die Aufgabe wird gelöst durch die Merkmale des unabhängigen Patentanspruchs. Vorteilhafte Ausgestaltungen der Erfindung sind in den Unteransprüchen gekennzeichnet.

Die Erfindung zeichnet sich aus durch eine strahlungsemittierende Vorrichtung, die aufweist ein strahlungsemittierendes Bauelement mit einem Schichtenstapel mit einem aktiven Bereich, der zur Emission elektromagnetischer Strahlung ausgebildet ist, und eine mit dem Schichtenstapel mechanisch gekoppelte Mikrostrukturschicht, die Erhebungen aufweist, die sich von dem Schichtenstapel weg erstrecken, wobei auf einer dem Schichtenstapel abgewandten Seite der Mikrostrukturschicht eine Schutzschicht angeordnet ist, die eine von der Mikrostrukturschicht abgewandte, plan ausgebildete Seite aufweist. Die Mikrostrukturschicht mit ihren Erhebungen dient dazu, einen hohen externen Wirkungsgrad, das heißt eine hohe Strahlungsauskopplung zu erreichen.

Die Schutzschicht mit ihrer plan ausgebildeten, von der Mikrostrukturschicht abgewandten Seite hat den Vorteil, dass eine Verschmutzung der strahlungsemittierenden Vorrichtung vermieden werden kann, und so eine hohe Stabilität des Wirkungsgrads der Strahlungsauskopplung aus der strahlungsemittierenden Vorrichtung über einen langen Zeitraum möglich ist. Außerdem übt die Schutzschicht eine schützende Wirkung gegenüber mechanischen Belastungen, wie beispielsweise Verkratzen, aus.

In einer vorteilhaften Ausführungsform hat die strahlungsemittierende Vorrichtung ein Substrat, das zwischen dem Schichtenstapel und der Mikrostrukturschicht angeordnet ist. Damit kann der Schichtenstapel fest auf dem Substrat und so stabil in der strahlungsemittierenden Vorrichtung angeordnet werden.

In einer weiteren vorteilhaften Ausführungsform hat die strahlungsemittierende Vorrichtung eine Dünnfilmverkapselung, die zwischen dem Schichtenstapel und der Mikrostrukturschicht angeordnet ist.

In einer weiteren vorteilhaften Ausführungsform sind zwischen den Erhebungen der Mikrostrukturschicht Ausnehmungen ausgebildet, und die Schutzschicht füllt die Ausnehmungen der Mikrostrukturschicht auf. So ist in vorteilhafter Weise ein einfacher Aufbau der Schutzschicht auf der Mikrostrukturschicht durch einfache mechanische Verfahren wie Giessen oder Streichen und/oder thermische Verfahren möglich.

In einer weiteren vorteilhaften Ausführungsform der strahlungsemittierenden Vorrichtung ist die Schutzschicht aus einem Material gebildet, das einen Brechungsindex aufweist, und das Substrat oder die Dünnfilmverkapselung ist aus einem Material gebildet, das einen Brechungsindex aufweist, und der Brechungsindex der Schutzschicht ist kleiner oder gleich wie der Brechungsindex des Substrats oder der Dünnfilmverkapselung. Dies hat den Vorteil, dass ein hoher externer Wirkungsgrad der Strahlungsauskopplung sichergestellt werden kann.

In einer weiteren vorteilhaften Ausführungsform weist die Mikrostrukturschicht ein Material mit einem Brechungsindex auf, und das Verhältnis des Brechungsindex des Materials der Mikrostrukturschicht zu dem Brechungsindex des Materials der Schutzschicht ist größer oder gleich 1,04. Damit ist vorteilhafterweise ein ausreichend großer optischer Kontrast der Schutzschicht gegenüber der Mikrostrukturschicht und damit ein hoher externer Wirkungsgrad der Strahlungsauskopplung möglich.

In einer weiteren vorteilhaften Ausführungsform ist die Schutzschicht aus einem Material gebildet, das aus der Gruppe der Polymere ausgewählt ist. Dies hat den Vorteil, dass die Schutzschicht beispielsweise durch einfache mechanische Verfahren wie Giessen oder Streichen oder ein thermisches Verfahren auf der Mikrostrukturschicht aufgebracht werden kann.

Weiterhin umfasst die strahlungsemittierende Vorrichtung eine Zwischenschicht, die zwischen der Mikrostrukturschicht und der Schutzschicht angeordnet ist. Damit können als vorgefertigte Platten ausgebildete Schutzschichten eingesetzt werden.

In einer weiteren vorteilhaften Ausführungsform ist die Zwischenschicht aus einem Material gebildet, das einen Brechungsindex aufweist, der kleiner oder gleich ist wie der Brechungsindex der Mikrostrukturschicht. Dies hat den Vorteil, dass ein hoher externer Wirkungsgrad der Strahlungsauskopplung sichergestellt werden kann.

In einer weiteren vorteilhaften Ausführungsform weist die Zwischenschicht eine Vakuumschicht auf. Dies hat den Vorteil, dass die Zwischenschicht keine oder eine sehr geringe thermische Ausdehnung aufweist und nicht auf Druckschwankungen von außen reagiert. Damit sind ein niedriger Brechungsindex des Materials in der Zwischenschicht und ein einfacher Aufbau des Verbunds aus Substrat, Mikrostrukturschicht und Schutzschicht möglich.

In einer weiteren vorteilhaften Ausführungsform weist die Zwischenschicht ein Gas auf, das aus der Gruppe von Luft, Stickstoff, Helium, Neon, Argon, Kohlendioxid und Fluorkohlenwasserstoffen ausgewählt ist. Damit ist ein einfacher Aufbau des Verbunds aus Substrat, Mikrostrukturschicht und Schutzschicht möglich. Des Weiteren kann ein niedriger Brechungsindex des Materials der Zwischenschicht erreicht werden.

In einer weiteren vorteilhaften Ausführungsform weist die Zwischenschicht eine Flüssigkeit auf, die aus der Gruppe von Wasser, Propanol und Heptan ausgewählt ist. Dies hat den Vorteil, dass die Zwischenschicht keine oder nur eine geringe thermische Ausdehnung hat und nicht auf Druckschwankungen von außen reagiert. Des Weiteren kann ein niedriger Brechungsindex des Materials der Zwischenschicht erreicht werden.

In einer weiteren vorteilhaften Ausführungsform ist die Mikrostrukturschicht derart ausgebildet, dass die Schutzschicht wenigstens teilweise an den Erhebungen der Mikrostrukturschicht anliegt. Dies hat den Vorteil, dass die Mikrostrukturschicht die Schutzschicht mechanisch stützen kann.

Ferner sind bei der strahlungsemittierenden Vorrichtung auf einer der Mikrostrukturschicht zugewandten Seite der Schutzschicht Strukturelemente angeordnet. Dies hat den Vorteil, dass die Emission der elektromagnetischen Strahlung der strahlungsemittierenden Vorrichtung definiert gerichtet sein kann.

In einer weiteren vorteilhaften Ausführungsform ist die Schutzschicht als starre Platte ausgebildet. Damit kann ein einfacher Aufbau des Verbunds aus der Mikrostrukturschicht und der Schutzschicht erreicht werden.

In einer weiteren vorteilhaften Ausführungsform hat die Schutzschicht eine Dicke zwischen 10 und 1000 µm. Damit ist eine dünne Ausgestaltung der gesamten strahlungsemittierenden Vorrichtung erreichbar.

In einer weiteren vorteilhaften Ausführungsform hat die Schutzschicht eine Dicke zwischen 50 und 200 µm. Damit ist eine sehr dünne Ausgestaltung der gesamten strahlungsemittierenden Vorrichtung erreichbar.

In einer weiteren vorteilhaften Ausführungsform ist die Mikrostrukturschicht aus einem Material gebildet, das einen Brechungsindex aufweist, der einen Wert von bis zu etwa 1,75 hat. Damit kann ein hoher externer Wirkungsgrad der Strahlungsauskopplung sichergestellt werden.

In einer weiteren vorteilhaften Ausführungsform ist die Mikrostrukturschicht aus einem Material gebildet ist, das aus der Gruppe von Polyimid, Polycarbonat und Polytetrafluorethylen ausgewählt ist. Damit sind ein hoher Brechungsindex des Materials der Mikrostrukturschicht und ein hoher externer Wirkungsgrad der Strahlungsauskopplung der strahlungsemittierenden Vorrichtung erreichbar.

In einer weiteren vorteilhaften Ausführungsform sind die Erhebungen der Mikrostrukturschicht als Kugelabschnitte ausgebildet. Dies hat den Vorteil, dass die Mikrostrukturschicht einfach herstellbar ist, und eine regelmäßige Struktur aufweisen kann.

In einer weiteren vorteilhaften Ausführungsform sind die Erhebungen der Mikrostrukturschicht als Pyramiden und/oder als Pyramidenstümpfe ausgebildet. Dies hat den Vorteil, dass die Mikrostrukturschicht einfach herstellbar ist, und eine regelmäßige Struktur aufweisen kann.

In einer weiteren vorteilhaften Ausführungsform sind die Erhebungen der Mikrostrukturschicht als Kegel und/oder Kegelstümpfe ausgebildet. Dies hat den Vorteil, dass die Mikrostrukturschicht einfach herstellbar ist, und eine regelmäßige Struktur aufweisen kann.

In einer weiteren vorteilhaften Ausführungsform weist das Substrat und/oder die Schutzschicht ein Material auf, das für die von dem aktiven Bereich emittierbare elektromagnetische Strahlung transparent ausgebildet ist. Transparent bedeutet hierbei, dass ein transparentes Element oder Bauteil zumindest für einen Teilbereich des Spektrums der emittierten Strahlung der strahlungsemittierenden Vorrichtung durchlässig ist. Bevorzugt kann transparent auch durchlässig für das gesamte Spektrum bedeuten. Dies hat den Vorteil, dass die von dem aktiven Bereich emittierte elektromagnetische Strahlung in einen Bereich außerhalb der strahlungsemittierenden Vorrichtung gelangen kann, in dem sie genutzt werden kann.

In einer weiteren vorteilhaften Ausführungsform ist das Substrat und/oder die Schutzschicht aus einem Material gebildet ist, das aus der Gruppe von Glas, Quarz, Kunststoff, Kunststoff mit Diffusionsbarriereschichten und Metall ausgewählt ist. Damit ist eine stabile, einfach herstellbare und kostengünstige Lösung für das Substrat und/oder die Schutzschicht möglich.

In einer weiteren vorteilhaften Ausführungsform ist das strahlungsemittierende Bauelement eine Leuchtdiode. Damit ist es möglich, die Schutzschicht für Leuchtdioden einzusetzen.

In einer weiteren vorteilhaften Ausführungsform ist das strahlungsemittierende Bauelement eine organische Leuchtdiode, die den zur Emission elektromagnetischer Strahlung ausgebildeten aktiven Bereich aufweist, und der aktive Bereich weist ein organisches Material auf. Damit ist es möglich, die Schutzschicht für organische Leuchtdioden einzusetzen.

In einer weiteren vorteilhaften Ausführungsform ist das strahlungsemittierende Bauelement flächenförmig ausgebildet. Dabei kann flächenförmig ausgebildet bedeuten, dass sich das strahlungsemittierende Bauelement zusammenhängend über einen Flächenbereich erstreckt, der zumindest eine Fläche von mehreren Quadratmillimetern, bevorzugt mehreren Quadratzentimetern und besonders bevorzugt zumindest einem oder mehreren Quadratdezimetern oder mehr aufweist. Damit ist es möglich, die Schutzschicht für flächenförmig ausgebildete strahlungsemittierende Bauelemente und damit auch für sehr flache strahlungsemittierende Bauelemente auszubilden.

Vorteilhafte Ausgestaltungen der Erfindung sind nachfolgend anhand der schematischen Zeichnungen näher erläutert.

Es zeigen:
- Figur 1: eine Schnittansicht einer Abwandlung einer strahlungsemittierenden Vorrichtung,
- Figuren 2 und 2a: Schnittansichten einer Abwandlung (Figur 2) und einer Ausführungsform (Figur 2a) einer strahlungsemittierenden Vorrichtung, und
- Figur 3: eine Schnittansicht einer weiteren Abwandlung einer strahlungsemittierenden Vorrichtung.

Elemente gleicher Konstruktion oder Funktion sind figurenübergreifend mit den gleichen Bezugszeichen gekennzeichnet. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche zur besseren Darstellbarkeit und/oder zum besseren Verständnis übertrieben dick oder groß dimensioniert dargestellt sein.

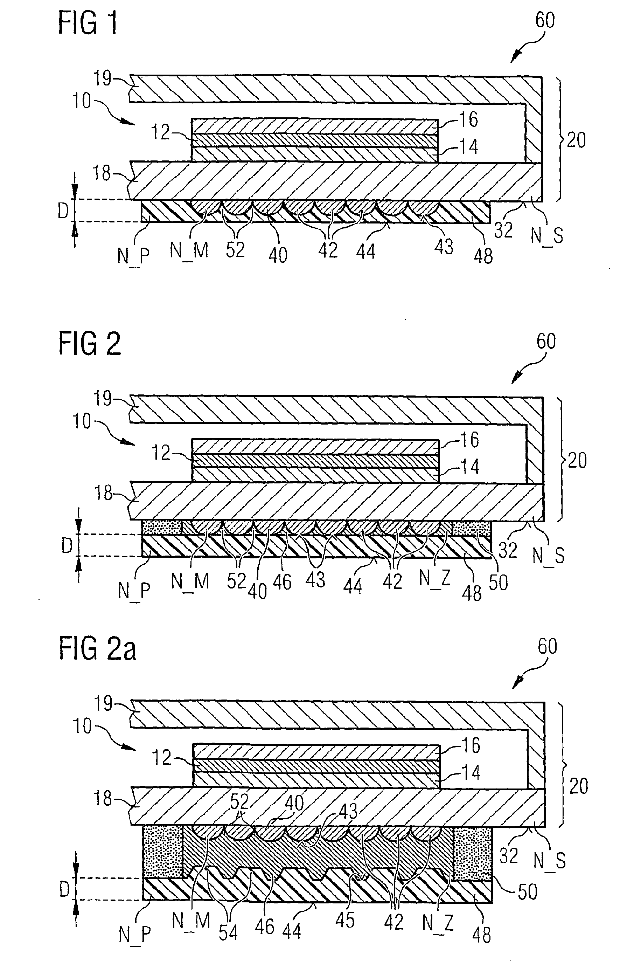

In Figur 1 ist eine Abwandlung einer strahlungsemittierenden Vorrichtung 60 gezeigt.

Die strahlungsemittierende Vorrichtung 60 weist ein strahlungsemittierendes Bauelement 20 mit einem Schichtenstapel 10 auf. Der Schichtenstapel 10 hat einen zur Emission elektromagnetischer Strahlung ausgebildeten aktiven Bereich 12.

Derartige strahlungsemittierende Vorrichtungen 60 sind bevorzugt so ausgebildet, dass das strahlungsemittierende Bauelement 20 eine Leuchtdiode oder ein Leuchtdiodenarray ist.

Besonders bevorzugt ist das strahlungsemittierende Bauelement 20 als organische Leuchtdiode (OLED, auf Englisch "Organic Light-Emitting Diode") ausgebildet. Als organische Leuchtdioden ausgebildete strahlungsemittierende Bauelemente 20 werden bevorzugt für Bildschirme (Fernseher, PC-Bildschirme, Displays für Automobile, Displays für Mobiltelefone, Touchscreen-Displays und ähnliches) verwendet. Ein weiteres Einsatzgebiet stellt die insbesondere großflächige Raumbeleuchtung dar.

Der aktive Bereich 12 der als organische Leuchtdiode ausgebildeten strahlungsemittierenden Vorrichtung 60 enthält bevorzugt ein organisches Material. Der aktive Bereich 12 kann organische Polymere, organische Oligomere, organische Monomere, organische kleine, nicht-polymere Moleküle ("Small Molecules") oder Kombinationen daraus aufweisen. Geeignete Materialien sowie Anordnungen und Strukturierungen der Materialien für den aktiven Bereich 12 sind dem Fachmann bekannt und werden daher an dieser Stelle nicht weiter ausgeführt. In dem aktiven Bereich 12 kann durch Elektronen- und Löcherrekombination elektromagnetische Strahlung mit einer einzelnen Wellenlänge oder einem Bereich von Wellenlängen erzeugt werden. Dabei kann bei einem Betrachter ein einfarbiger, ein mehrfarbiger und/oder ein mischfarbiger Leuchteindruck erweckt werden.

Die vom aktiven Bereich 12 des strahlungsemittierenden Bauelements 20 erzeugte elektromagnetische Strahlung kann insbesondere ein Spektrum mit Wellenlängen in einem ultravioletten bis infraroten Spektralbereich aufweisen. Insbesondere kann es vorteilhaft sein, wenn das Spektrum zumindest eine für einen Betrachter sichtbare Wellenlänge umfasst. Das Spektrum der elektromagnetischen Strahlung kann vorteilhafterweise auch mehrere Wellenlängen umfassen, so dass bei einem Betrachter ein mischfarbiger Leuchteindruck entstehen kann. Dazu kann es möglich sein, dass das strahlungsemittierende Bauelement 20 selbst elektromagnetische Strahlung mit mehreren Wellenlängen erzeugen kann oder dass ein Teil der vom organischen strahlungsemittierenden Bauelement 20 erzeugten elektromagnetischen Strahlung oder die gesamte vom strahlungsemittierenden Bauelement 20 erzeugte elektromagnetische Strahlung mit einer ersten Wellenlänge, etwa in einem blauen und/oder grünen Spektralbereich, durch einen Wellenlängenkonversionsstoff in eine zweite Wellenlänge, etwa in einem gelben und/oder roten Spektralbereich umgewandelt wird. Dazu kann dem aktiven Bereich 12 eine Schicht oder ein Bereich nachgeordnet sein, der einen Wellenlängenkonversionsstoff aufweist. Geeignete Wellenlängenkonversionsstoffe und Schichten mit Wellenlängenkonversionsstoffen sind hinsichtlich ihrem Aufbau und ihrer Funktion dem Fachmann bekannt und werden an dieser Stelle nicht näher erläutert.

Benachbart zu dem aktiven Bereich 12 sind Elektroden 14, 16 angeordnet. Insbesondere können die Elektroden 14, 16 flächig oder in Teilbereiche strukturiert ausgeführt sein. Die Elektrode 14 ist bezüglich der Figuren unterhalb des aktiven Bereichs 12 angeordnet. Die Elektrode 14 ist bevorzugt als Anode ausgeführt, womit sie als Löcher induzierendes Element dienen kann.

Die Elektrode 14 ist insbesondere als elektrisch leitendes Oxid, dünner transparenter Metallfilm oder als eine Kombination aus elektrisch leitendem Oxid und dünnem transparenten Metallfilm ausgebildet. Besonders bevorzugt ist die Ausbildung der Elektrode 14 als transparentes elektrisch leitendes Oxid (Transparent Conductive Oxid, TCO).

Transparente elektrisch leitende Oxide sind transparente leitende Materialien, in der Regel Metalloxide, wie beispielsweise Zinkoxid, Zinnoxid, Cadmiumoxid, Titanoxid, Indiumoxid oder besonders bevorzugt Indium-Zinnoxid (ITO). Neben binären Metall-Sauerstoffverbindungen, wie beispielsweise ZnO, SnO₂ oder In₂O₃ gehören auch ternäre Metall-SauerstoffVerbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter elektrisch leitender Oxide zu der Gruppe der transparenten elektrisch leitenden Oxide. Weiterhin müssen die transparenten elektrisch leitenden Oxide nicht zwingend einer stöchiometrischen Zusammensetzung entsprechen und können auch p- oder n-dotiert sein.

Die Kombination aus elektrisch leitendem Oxid und dünnem transparenten Metallfilm ist besonders bevorzugt als eine Schichtenfolge aus Indium-Zinnoxid (ITO) und dem Metall ausgebildet (ITO/Metall/ITO, IMI).

Die bezüglich der Figuren oberhalb des aktiven Bereichs 12 angeordnete Elektrode 16 ist bevorzugt als Kathode ausgeführt und dient somit als Elektronen induzierendes Element. Alternativ ist die oberhalb des aktiven Bereichs 12 angeordnete Elektrode 16 als Anode ausgebildet. Als Material für diese Elektrode können insbesondere Aluminium, Barium, Indium, Silber, Gold, Magnesium, Kalzium oder Lithium sowie Verbindungen, Kombinationen und Legierungen davon vorteilhaft sein.

Der Schichtenstapel 10 ist auf einem Substrat 18 angeordnet. Besonders bevorzugt ist, wenn das Substrat 18 Glas aufweist. Alternativ oder zusätzlich kann das Substrat 18 auch Quarz, Kunststofffolien, Metall, Metallfolien, Siliziumwafer oder ein beliebiges anderes geeignetes Substratmaterial umfassen. Alternativ oder zusätzlich kann das Substrat 18 auch ein Laminat oder eine Schichtenfolge aus mehreren Schichten aufweisen. Dabei kann zumindest eine der Schichten Glas aufweisen oder aus Glas sein. Insbesondere kann bei einem aus einer Schichtenfolge gebildeten Substrat 18 zumindest die Schicht Glas aufweisen, auf der der Schichtenstapel 10 angeordnet ist. Darüber hinaus kann das Substrat 18 auch Kunststoff aufweisen.

Die strahlungsemittierende Vorrichtung 60 weist weiter ein als Verkapselung ausgebildetes Substrat 19 auf, die derart mit dem Substrat 18 gekoppelt ist, dass der Schichtenstapel 10 mit den dazugehörigen Elektroden 14, 16 und dem aktiven Bereich 12 vor Feuchtigkeit und/oder oxidierenden Substanzen wie etwa Sauerstoff geschützt werden können. Die Verkapselung 19 kann vorzugsweise eine oder mehrere Schichten umfassen, wobei das als Verkapselung ausgebildete Substrat 19 vorzugsweise Planarisierungsschichten, Barriereschichten, Wasser und/oder Sauerstoff absorbierende Schichten, Verbindungsschichten oder Kombinationen daraus aufweist.

Ist die strahlungsemittierende Vorrichtung 60 als organische Leuchtdiode und dabei insbesondere, wie in den Figuren 1 und 2 dargestellt, als so genannter "Bottom-Emitter" ausgeführt, das heißt, dass die in dem aktiven Bereich 12 emittierte elektromagnetische Strahlung durch das Substrat 18 hindurch abgestrahlt wird, so kann das Substrat 18 vorteilhafterweise eine Transparenz für zumindest einen Teil der im aktiven Bereich 12 erzeugten elektromagnetischen Strahlung aufweisen. In der "Bottom-Emitter"-Konfiguration kann vorteilhafterweise auch die als Anode ausgebildete Elektrode 14 eine Transparenz zumindest für einen Teil der im aktiven Bereich 12 erzeugten elektromagnetischen Strahlung aufweisen.

Auf einer dem strahlungsemittierenden Bauelement 20 abgewandten Seite 32 des Substrats 18 ist eine Mikrostrukturschicht 40 angeordnet. Die Mikrostrukturschicht 40 hat Erhebungen 42, die sich von dem Schichtenstapel 10 weg erstrecken. Zwischen den Erhebungen 42 der Mikrostrukturschicht 40 sind Ausnehmungen 52 ausgebildet.

Die Erhebungen 42 sind vorzugsweise eindimensional oder zweidimensional gestaltet. Eindimensionale Erhebungen 42 sind bevorzugt trapezoid, dreieckig oder als Kreissegmentquerschnitte ausgebildet. Zweidimensional strukturierte Erhebungen 42 der Mikrostrukturschicht 40 sind vorzugsweise als Pyramiden oder Pyramidenstümpfe, als Kegel oder Kegelstümpfe oder als Kugelabschnitte ausgebildet. Die Mikrostrukturschicht 40 ist bevorzugt aus einem Material gebildet, das einen Brechungsindex N_M aufweist. Der Brechungsindex N_M der Mikrostrukturschicht 40 hat vorzugsweise einen Wert von etwa bis zu 1,75. Besonders bevorzugt ist, wenn die Mikrostrukturschicht 40 aus einem Material gebildet ist, das aus einer Gruppe aus Polyimid, Polycarbonat und Polytetrafluorethylen ausgewählt ist. Diese Materialien können einen hohen Brechungsindex bis zu 1,75 haben.

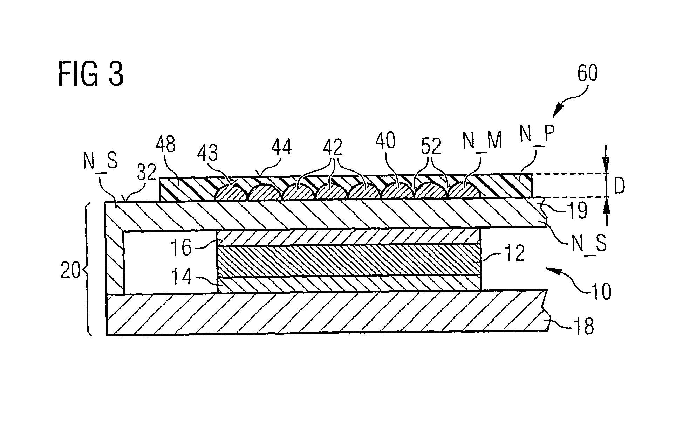

Figur 3 zeigt eine Abwandlung der strahlungsemittierenden Vorrichtung 60 wie in der Figur 1, jedoch ist hier das als Verkapselung ausgebildete Substrat 19 zwischen der Mikrostrukturschicht 40 und dem Schichtenstapel 10 angeordnet. Die strahlungsemittierende Vorrichtung 60 ist hier als so genannter "Top-Emitter" ausgeführt, das heißt, dass die in dem aktiven Bereich 12 emittierte elektromagnetische Strahlung durch das als Verkapselung ausgebildete Substrat 19 hindurch abgestrahlt wird. Das als Verkapselung ausgebildete Substrat 19 weist hier vorteilhafterweise eine Transparenz für zumindest einen Teil der im aktiven Bereich 12 erzeugten elektromagnetischen Strahlung auf. In der "Top-Emitter"-Konfiguration kann vorteilhafterweise auch die oberhalb des aktiven Bereichs 12 angeordnete Elektrode 16 eine Transparenz zumindest für einen Teil der im aktiven Bereich 12 erzeugten elektromagnetischen Strahlung aufweisen.

Soll mindestens eine der Elektroden 14,16, die die Schicht aus elektrisch leitendem Oxid, dünnem transparenten Metallfilm oder der Kombination aus elektrisch leitendem Oxid und dünnem transparenten Metallfilm aufweist oder aus einer solchen besteht, durchlässig für das von dem organischen Schichtenstapel 10 ausgesandte Licht ausgebildet sein, so kann es vorteilhaft sein, wenn diese Schicht hinreichend dünn ausgebildet ist. Bevorzugt liegt die Dicke einer solchen semitransparenten Schicht zwischen 1 nm und 100 nm, wobei die Grenzen eingeschlossen sind.

Die Mikrostrukturschicht 40 hat eine dem Schichtenstapel 10 abgewandte Seite 43, auf der eine Schutzschicht 48 angeordnet ist. Die Schutzschicht 48 hat eine von der Mikrostrukturschicht 40 abgewandte Seite 44, die plan ausgebildet ist.

Durch die plane Ausbildung der von der Mikrostrukturschicht 40 abgewandten Seite 44 der Schutzschicht 48 kann erreicht werden, dass die strahlungsemittierende Vorrichtung 60 an ihrer Oberfläche glatt ausgebildet ist, so dass Verschmutzungen der strahlungsemittierenden Vorrichtung 60 besonders leicht vermieden werden können. Des Weiteren ist die Handhabung der strahlungsemittierenden Vorrichtung 60 vereinfacht, da die von der Mikrostrukturschicht 40 abgewandte plan ausgebildete Seite 44 unempfindlich gegenüber mechanischen Einflüssen sein kann. Dies gilt insbesondere auch dann, wenn die strahlungsemittierende Vorrichtung 60 in weitergehenden Anwendungen benutzt wird, beispielsweise durch Aufbringen auf einen mechanischen Träger.

In den Figuren 1 und 3 füllt die Schutzschicht 48 die Ausnehmung 52 der Mikrostrukturschicht 40 aus. Die Schutzschicht 48 ist hier bevorzugt aus einem Material gebildet, das einen Brechungsindex N_P aufweist, und das Substrat 18 ist aus einem Material gebildet, das einen Brechungsindex N_S aufweist. Vorzugsweise ist der Brechungsindex N_P der Schutzschicht 48 kleiner oder höchstens gleich dem Brechungsindex N_S des Substrats 18. Damit kann erreicht werden, dass die strahlungsemittierende Vorrichtung 60 einen hohen externen Wirkungsgrad der Strahlungsauskopplung erreicht.

Hat die Mikrostrukturschicht 40 ein Material mit dem Brechungsindex N_M und ist das Verhältnis des Brechungsindex N_M des Materials der Mikrostrukturschicht 40 zu dem Brechungsindex N_P des Materials der Schutzschicht 48 größer oder gleich 1,04, so kann ein guter optischer Kontrast zwischen der Mikrostrukturschicht 40 und der Schutzschicht 48 erreicht werden. Damit ist es möglich, dass ein hoher externer Wirkungsgrad der Strahlungsauskopplung der strahlungsemittierenden Vorrichtung 60 erreicht wird.

Besonders bevorzugt ist die Schutzschicht 48 aus einem Material gebildet, das aus der Gruppe der Polymere ausgewählt ist, und die Mikrostrukturschicht 40 ist aus einem Material gebildet, das ein Polyimid ist. Da der Brechungsindex von Polymeren im Bereich von 1,4 bis 1,55 und der Brechungsindex von Polyimiden deutlich darüber liegt, kann ein besonders guter optischer Kontrast zwischen der Mikrostrukturschicht 40 und der Schutzschicht 48 und damit ein besonders hoher Wirkungsgrad der Auskopplung der Strahlung aus der strahlungsemittierenden Vorrichtung 60 erreicht werden.

Die Figur 2 zeigt eine Abwandlung und die Figur 2a zeigt eine Ausführungsform der strahlungsemittierenden Vorrichtung 60 mit der Mikrostrukturschicht 40 und der Schutzschicht 48, bei der zwischen der Mikrostrukturschicht 40 und der Schutzschicht 48 eine Zwischenschicht 46 angeordnet ist.

Besonders bevorzugt ist, wenn die Schutzschicht 48 als starre Platte ausgebildet ist. Es ist so sehr einfach, einen stabilen Verbund aus der Mikrostrukturschicht 40 und der Schutzschicht 48 zu erreichen. Die Schutzschicht 48 ist in der hier gezeigten Ausführungsform mittels einer Klebeschicht 50 mit dem Substrat 18 mechanisch fest gekoppelt. Damit kann ein besonders stabiler Aufbau eines Verbunds aus der Schutzschicht 48, der Mikrostrukturschicht 40 und dem Substrat 18 erreicht werden.

Ist die Zwischenschicht 46 aus einem Material mit einem Brechungsindex N_Z gebildet, der kleiner oder gleich wie der Brechungsindex N_M der Mikrostrukturschicht 40 ist, so kann ein besonders hoher Wirkungsgrad der Strahlungsauskopplung der strahlungsemittierenden Vorrichtung 60 erzielt werden.

Dies lässt sich besonders gut erreichen, wenn die Zwischenschicht 46 eine Vakuumschicht ist. Da der Brechungsindex von Vakuum gleich 1 ist, kann so ein besonders hoher Wirkungsgrad der Strahlungsauskopplung der strahlungsemittierenden Vorrichtung 60 erreicht werden.

In einer weiteren Ausführungsform kann die Zwischenschicht 46 insbesondere mit einem Gas, besonders bevorzugt mit Luft, Stickstoff, Kohlendioxid, Helium, Neon, Argon oder einem Fluorkohlenwasserstoff gefüllt sein. Diese Gase sind chemisch besonders stabil und weisen einen niedrigen Brechungsindex, in der Regel nahe 1, auf. Es kann so ein hoher Wirkungsgrad der Strahlungsauskopplung der strahlungsemittierenden Vorrichtung 60 erreicht werden.

In weiteren Ausführungsformen ist die Zwischenschicht 46 mit einer Flüssigkeit gefüllt, wobei insbesondere Wasser, Propanol und Heptan bevorzugt sind. Bei diesen Flüssigkeiten werden nur geringe thermische und druckabhängige Ausdehnungen der Zwischenschicht 46 erreicht. Des Weiteren weisen diese Flüssigkeiten einen niedrigen Brechungsindex auf. Auch hier kann ein hoher Wirkungsgrad der Strahlungsauskopplung der strahlungsemittierenden Vorrichtung 60 erreicht werden.

In der Abwandlung der Figur 2 liegt die Schutzschicht 48 teilweise an den Erhebungen 42 der Mikrostrukturschichten 40 an. Damit dient die Mikrostrukturschicht 40 als Stützschicht für die Schutzschicht 48.

In der Ausführungsform gemäß Figur 2a kann die Schutzschicht 48 jedoch auch etwas von der Mikrostrukturschicht 40 beabstandet sein.

Auf einer der Mikrostrukturschicht 40 zugewandten Seite 45 der Schutzschicht 48 sind Strukturelemente 54 angeordnet . Die Strukturelemente 54 der Schutzschicht 48 sind bevorzugt als Pyramiden, Prismen, Konusse oder Kugelabschnitte ausgebildet, die jeweils auch zweidimensional strukturiert sein können. Damit kann die Emission der elektromagnetischen Strahlung der strahlungsemittierenden Vorrichtung definiert gerichtet werden.

Die Schutzschicht 48 ist bevorzugt aus einem Material gebildet, das für die von dem aktiven Bereich 12 emittierbare elektromagnetische Strahlung transparent ausgebildet ist. Die Schutzschicht 48 kann beispielsweise aus einem Material gebildet sein, das Glas, Quarz oder einen transparenten Kunststoff aufweist. Die Schutzschicht 48 kann auch aus Glas, aus Quarz oder einem transparenten Kunststoff sein.

Die Schutzschicht 48 weist bevorzugt eine Dicke D zwischen 10 und 1000 µm auf. Damit ist es möglich, die strahlungsemittierende Vorrichtung 60 flach auszubilden. Besonders bevorzugt ist, wenn die Schutzschicht eine Dicke D zwischen 50 und 200 µm hat, da so die strahlungsemittierende Vorrichtung 60 sehr flach ausgebildet werden kann.

Besteht die Schutzschicht 48 der Abwandlung der Figur 2 aus einer Glasplatte, so ist bevorzugt, wenn die Dicke D der Schutzschicht 48 etwa 700 µm beträgt. Die Schutzschicht 48 aus einer Glasplatte mit der Dicke D von etwa 700 µm ist einerseits gut handhabbar, andererseits trägt die Schutzschicht 48 nur unwesentlich zu einer Gesamtdicke der strahlungsemittierenden Vorrichtung 60 bei. Es ist so möglich, dass der Wert der ausgekoppelten Lichtleistung der strahlungsemittierenden Vorrichtung 60 für eine derartig ausgebildete Schutzschicht 48 gegenüber der strahlungsemittierenden Vorrichtung 60 ohne Schutzschicht 48 nur um wenige Prozent reduziert ist.

Bevorzugt ist das strahlungsemittierende Bauelement 20 flächenförmig ausgebildet.

Weiterhin kann die strahlungsemittierende Vorrichtung 60 optische Elemente aufweisen, die dem aktiven Bereich 12 in Abstrahlrichtung der elektromagnetischen Strahlung nachgeordnet sind. Insbesondere kann etwa auf der Außenseite des Substrats 18 (beim "Bottom-Emitter") oder über dem als Verkapselung ausgebildeten Substrat 19 (bei einem "Top-Emitter") ein Zirkularpolarisator angeordnet sein, mit dem auf vorteilhafte Weise vermieden werden kann, dass Licht, das von außen in die strahlungsemittierende Vorrichtung 60 hineingestrahlt wird und das beispielsweise an den Elektroden 14, 16 reflektiert werden kann, wieder aus der strahlungsemittierenden Vorrichtung 60 austreten kann.

Alternativ kann das strahlungsemittierende Bauelement 20 als elektrolumineszierende Folie ausgebildet sein. Dabei kann ein aktiver Bereich, der ein anorganisches Material, beispielsweise basierend auf Zinksulfid, aufweist, zwischen zwei Elektroden angeordnet sein. Diese Elektroden können dabei Merkmale und Strukturen wie im Zusammenhang mit den organischen strahlungsemittierenden Bauelementen 20 beschrieben, aufweisen. Der aktive Bereich kann eine geeignete Dotierung, etwa Kupfer oder Europium, aufweisen.

Die beschriebenen strahlungsemittierenden Vorrichtungen 60 können durch die schon geschilderten Vorteile einer langen Lebensdauer bei hoher Strahlungsauskopplung eine hohe Wirtschaftlichkeit und geringe Kosten ermöglichen. Insbesondere können eine geringe Verschmutzung und damit niedrige Reinigungskosten erreicht werden. Durch die weitgehende Unempfindlichkeit der Oberflächen gegenüber mechanischen Beanspruchungen kann eine gute Weiterbearbeitung der strahlungsemittierenden Vorrichtung 60 ermöglicht werden.

Derartige strahlungsemittierende Vorrichtungen 60 können geeignet sein für eine Verwendung in Anzeige- und/oder Beleuchtungseinrichtungen, die sich durch eine kompakte, Platz sparende und flache Bauform auszeichnen.

## Patentansprüche

1. Strahlungsemittierende Vorrichtung (60), die aufweist
- ein strahlungsemittierendes Bauelement (20) mit einem Schichtenstapel (10) mit einem aktiven Bereich (12), der zur Emission elektromagnetischer Strahlung ausgebildet ist,
- eine mit dem Schichtenstapel (10) mechanisch gekoppelte Mikrostrukturschicht (40), die Erhebungen (42) aufweist, die sich von dem Schichtenstapel (10) weg erstrecken, und
- eine Zwischenschicht (46), die zwischen der Mikrostrukturschicht (40) und der Schutzschicht (48) angeordnet ist,
wobei auf einer dem Schichtenstapel (10) abgewandten Seite (43) der Mikrostrukturschicht (40) eine Schutzschicht (48) angeordnet ist, die eine von der Mikrostrukturschicht (40) abgewandte, plan ausgebildete Seite (44) aufweist,
wobei auf einer der Mikrostrukturschicht (40) zugewandten Seite (45) der Schutzschicht (48) Strukturelemente (54) angeordnet sind,
**dadurch gekennzeichnet,**
**dass** eine Emission der elektromagnetischen Strahlung der strahlungsemittierenden Vorrichtung mit den Strukturelementen (54) durch die Schutzschicht (48) hindurch definiert gerichtet werden kann.

2. Strahlungsemittierende Vorrichtung (60) nach Anspruch 1, wobei die Zwischenschicht (46) aus einem Material gebildet ist, das einen Brechungsindex (N_Z) aufweist, der kleiner oder gleich ist wie der Brechungsindex (N_M) der Mikrostrukturschicht (40).

3. Strahlungsemittierende Vorrichtung (60) nach Anspruch 1 oder 2, wobei die Zwischenschicht (46) eine Flüssigkeit aufweist, die aus der Gruppe von Wasser, Propanol und Heptan ausgewählt ist, oder wobei die Zwischenschicht (46) eine Vakuumschicht ist.

4. Strahlungsemittierende Vorrichtung (60) nach einem der vorhergehenden Ansprüche, wobei die Mikrostrukturschicht (40) derart ausgebildet ist, dass die Schutzschicht (48) wenigstens teilweise an den Erhebungen (42) der Mikrostrukturschicht (40) anliegt.

5. Strahlungsemittierende Vorrichtung (60) nach einem der vorhergehenden Ansprüche, wobei die Schutzschicht (48) als starre Platte ausgebildet ist.

6. Strahlungsemittierende Vorrichtung (60) nach einem der vorhergehenden Ansprüche, wobei die Schutzschicht (48) eine Dicke (D) zwischen 10 µm und 1000 µm hat.

7. Strahlungsemittierende Vorrichtung (60) nach dem vorhergehenden Anspruch, wobei die Schutzschicht (48) eine Dicke (D) zwischen 50 µm und 200 µm hat.

8. Strahlungsemittierende Vorrichtung (60) nach einem der vorhergehenden Ansprüche, wobei die Mikrostrukturschicht (40) aus einem Material gebildet ist, das einen Brechungsindex (N_M) aufweist, der einen Wert von bis zu 1,75 hat.

9. Strahlungsemittierende Vorrichtung (60) nach einem der vorhergehenden Ansprüche, wobei die Mikrostrukturschicht (40) aus einem Material gebildet ist, das aus der Gruppe von Polyimid, Polycarbonat und Polytetrafluorethylen ausgewählt ist.

10. Strahlungsemittierende Vorrichtung (60) nach einem der vorhergehenden Ansprüche, wobei die Erhebungen (42) der Mikrostrukturschicht (40) als Pyramiden und/oder als Pyramidenstümpfe und/oder als Kegel und/oder Kegelstümpfe ausgebildet sind.

## Claims

1. Radiation-emitting device (60) comprising
- a radiation-emitting component (20) having a layer stack (10) having an active region (12) designed for emitting electromagnetic radiation,
- a microstructure layer (40), which is mechanically coupled to the layer stack (10) and which has elevations (42) extending away from the layer stack (10), and
- an intermediate layer (46) arranged between the microstructure layer (40) and the protective layer (48), wherein a protective layer (48) is arranged on a side (43) of the microstructure layer (40) facing away from the layer stack (10), said protective layer having a side (44) which faces away from the microstructure layer (40) and which is embodied in a planar fashion,
wherein structure elements (54) are arranged on a side (45) of the protective layer (48) facing the microstructure layer (40),
**characterized in that** an emission of the electromagnetic radiation of the radiation-emitting device can be directed in a defined manner through the protective layer (48) with the structure elements (54).

2. Radiation-emitting device (60) according to Claim 1,
wherein the intermediate layer (46) is formed from a material having a refractive index (N_Z) which is less than or equal to the refractive index (N_M) of the microstructure layer (40).

3. Radiation-emitting device (60) according to Claim 1 or 2, wherein the intermediate layer (46) comprises a liquid selected from the group of water, propanol and heptane, or wherein the intermediate layer (46) is a vacuum layer.

4. Radiation-emitting device (60) according to any of the preceding claims, wherein the microstructure layer (40) is embodied in such a way that the protective layer (48) at least partly bears against the elevations (42) of the microstructure layer (40).

5. Radiation-emitting device (60) according to any of the preceding claims, wherein the protective layer (48) is embodied as a rigid plate.

6. Radiation-emitting device (60) according to any of the preceding claims, wherein the protective layer (48) has a thickness (D) of between 10 µm and 1000 µm.

7. Radiation-emitting device (60) according to the preceding claim, wherein the protective layer (48) has a thickness (D) of between 50 µm and 200 µm.

8. Radiation-emitting device (60) according to any of the preceding claims, wherein the microstructure layer (40) is formed from a material having a refractive index (N_M) which has a value of up to 1.75.

9. Radiation-emitting device (60) according to any of the preceding claims, wherein the microstructure layer (40) is formed from a material selected from the group of polyimide, polycarbonate and polytetra-fluoroethylene.

10. Radiation-emitting device (60) according to any of the preceding claims, wherein the elevations (42) of the microstructure layer (40) are embodied as pyramids and/or as truncated pyramids and/or as cones and/or truncated cones.

## Revendications

1. Dispositif (60) émettant un rayonnement, le dispositif présentant :
un composant (20) émettant un rayonnement et doté d'un empilement (10) de couches qui présente une partie active (12) configurée pour émettre un rayonnement électromagnétique,
une couche microstructurée (40) couplée mécaniquement à l'empilement (10) de couches et qui présente des rehaussements (42) qui s'éloignent de l'empilement (10) de couches et
une couche intermédiaire (46) disposée entre la couche microstructurée (40) et la couche de protection (48),
une couche de protection (48) qui présente un côté plan (44) non tourné vers la couche microstructurée (40) étant disposée sur le côté (43) de la couche microstructurée (40) non tourné vers l'empilement (10) de couches, des éléments structurels (54) étant disposés sur le côté (45) de la couche de protection (48) tourné vers la couche microstructurée (40),
**caractérisé en ce que**
l'émission du rayonnement électromagnétique du dispositif émettant un rayonnement peut être orientée de manière définie à travers la couche de protection (48) par les éléments structurels (54).

2. Dispositif (60) émettant un rayonnement selon la revendication 1, dans lequel la couche intermédiaire (46) est formée d'un matériau dont l'indice de diffraction (N_Z) est inférieur ou égal à l'indice de réfraction (N_M) de la couche microstructurée (40).

3. Dispositif (60) émettant un rayonnement selon les revendications 1 ou 2, dans lequel la couche intermédiaire (46) présente un liquide sélectionné dans l'ensemble constitué de l'eau, du propanol et de l'heptane, ou la couche intermédiaire (46) étant une couche sous vide.

4. Dispositif (60) émettant un rayonnement selon l'une des revendications précédentes, dans lequel la couche microstructurée (40) est configurée de telle sorte que la couche de protection (48) repose au moins en partie sur les rehaussements (42) de la couche microstructurée (40) .

5. Dispositif (60) émettant un rayonnement selon l'une des revendications précédentes, dans lequel la couche de protection (48) est configurée en plaque rigide.

6. Dispositif (60) émettant un rayonnement selon l'une des revendications précédentes, dans lequel la couche de protection (48) présente une épaisseur (D) comprise entre 10 µm et 1000 µm.

7. Dispositif (60) émettant un rayonnement selon la revendication précédente, dans lequel la couche de protection (48) présente une épaisseur (D) comprise entre 50 µm et 200 µm.

8. Dispositif (60) émettant un rayonnement selon l'une des revendications précédentes, dans lequel la couche microstructurée (40) est formée d'un matériau dont l'indice de réfraction (N_M) a une valeur pouvant atteindre 1,75 au maximum.

9. Dispositif (60) émettant un rayonnement selon l'une des revendications précédentes, dans lequel la couche microstructurée (40) est formée d'un matériau sélectionné dans l'ensemble constitué du polyimide, du polycarbonate et du polytétrafluoroéthylène.

10. Dispositif (60) émettant un rayonnement selon l'une des revendications précédentes, dans lequel les rehaussements (42) de la couche microstructurée (40) sont configurés en pyramide, en tronc de pyramide, en cône et/ou en tronc de cône.
